(19) Europäisches Patentamt
European Patent Office
Office européen des brevets

(11) **EP 2 509 112 A1**

(12) **EUROPEAN PATENT APPLICATION**
published in accordance with Art. 153(4) EPC

(43) Date of publication:
**10.10.2012 Bulletin 2012/41**

(51) Int Cl.:
***H01L 31/042*** *(2006.01)*

(21) Application number: **10762853.9**

(22) Date of filing: **25.11.2010**

(86) International application number:
**PCT/JP2010/070960**

(87) International publication number:
**WO 2011/068067 (09.06.2011 Gazette 2011/23)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **03.12.2009 JP 2009275264**

(71) Applicant: **Toray Industries, Inc.**
**Tokyo 103-8666 (JP)**

(72) Inventors:
• **KAMEDA, Shunsuke**
**Otsu-shi**
**Shiga 520-8558 (JP)**
• **ARAI, Takashi**
**Otsu-shi**
**Shiga 520-8558 (JP)**
• **HIROTA, Kusato**
**Otsu-shi**
**Shiga 520-8558 (JP)**

(74) Representative: **Hoefer & Partner**
**Pilgersheimer Straße 20**
**81543 München (DE)**

(54) **FILM FOR BACKSIDE SEALING SHEET OF SOLAR CELL**

(57) The film for a backside sealing sheet of a solar cell according to the present invention comprises a base film with at least one of its surfaces being laminated with a resin layer containing a resin produced through copolymerization of an acrylic polyol resin with an ultraviolet absorbent and/or a light stabilizer, along with a conductive material and a coloring pigment, wherein the conductive material accounts for 5 to 20 mass% of the total mass of the resin layer, and the resin layer has a surface resistivity of $1.0 \times 10^9$ to $1.0$ to $10^{15}$ $\Omega$/square. The present invention provides a film for a backside sealing sheet of a solar cell excellent in partial discharge voltage, which is an index representing the light resistance and electrical insulation.

EP 2 509 112 A1

## Description

[Technical Field]

The present invention relates to a film for a backside sealing sheet of a solar cell having properties of light resistance and electric insulation which allow the film to be used under severe outdoor conditions over a long period of time. The present invention also relates to a backside sealing sheet of a solar cell and a solar cell module which use the film for a backside sealing sheet of a solar cell of the present invention.

[Background of the Invention]

In recent years, fossil fuels such as oil and coal are in danger of running out. Development for securing alternative energies obtained with these fossil fuels is imperative. Thus, various methods, such as nuclear power generation, water power generation, wind power generation, and solar power generation, have been studied and actually used. The solar power generation that directly converts solar energy into electric energy has been practically used as a new, semi-permanent, environmentally-clean energy source. The solar power generation has been remarkably improved in its cost performance in actual use and much expected as a clean energy source.

Solar cells used for solar power generation constitute the core of a solar power generation system that converts the energy of sunlight to electric energy. A solar cell is made of a semiconductor material such as silicon. A solar cell is in the form of a unit in which solar cell elements are arranged in series and in parallel, and placed in any of various kinds of packages to protect the elements over a long period of time, about 20 years. The unit incorporated in the package is called a solar cell module. The solar cell module is constructed so that the sunny side is covered with glass, the gap formed is filled with a filler made of a thermoplastic resin, and the backside is protected with a sealing sheet. As such a filler, in many cases, an ethylene vinyl acetate copolymer resin (hereinafter, referred to as EVA resin) is used because it has high transparency and excellent moisture resistance. On the other hand, the backside sheet requires properties including mechanical strength, weather resistance, heat resistance, water resistance, light resistance, chemical resistance, light reflection, and moisture barrier, and also thermal adhesiveness to a filler typified by EVA resin. In addition to these properties, the backside sealing sheet requires an excellent light resistance because of ultraviolet exposure and an excellent electric insulating property from a viewpoint of preventing short-circuiting in the solar cell system.

An exemplary backside-sealing sheet film which has been used in the art can be a white polyvinyl fluoride film (E. I. du Pont de Nemours and Company, trade name: Tedlar (registered trademark)). A backside sealing sheet having a laminated structure where a polyester film is sandwiched between polyvinyl fluoride film has been widely used in solar cell applications. In addition, a sheet laminated with a polyester-based film with excellent weather resistance and gas barrier has been proposed (Patent Document 1). Furthermore, a backside sealing sheet of a solar cell requires resistance to a partial discharge voltage of 700 V or 1,000 V depending on the power-generating capacity of the cell to protect the solar cell module from being damaged by application of voltage. Thus, proposals for increasing the partial discharge voltage have been made. For instance, as a method for improving an anti-partial discharge voltage, providing a solar cell module with an electrically insulated film or a foaming layer has been proposed (Patent Document 2).

[Prior Art Documents]

[Patent Documents]

[Patent Document 1]

Japanese Unexamined Patent Application Publication (Kokai) No. 2002-100788
Japanese Unexamined Patent Application Publication (Kokai) No. 2006-253264

[Summary of the Invention]

[Problems to be Solved by the Invention]

However, the aforementioned polyvinyl fluoride film is excellent in weather resistance but poor in mechanical strength. In some cases, therefore, softening may occur under heat of 140 to 150°C applied by heat pressing when a solar cell module is produced, and a protrusion of the electrode part of a solar cell element may penetrate the filler layer. Furthermore, it may become an obstacle to price reduction of the solar cell module due to its high price. In addition, for electric resistance property, as the partial discharge voltage of a resin film depends on the thickness of the film, the resin film has to be made thicker. Thus, an increase in cost inevitably occurs along with a decrease in workability at the time of cutting. In the case of the solar cell module including the foaming layer of Patent Document 2, the adhesion between films bonded together decreases because cleavage (cohesive failure) can occur easily in films having a foaming layer. In recent years, furthermore, mainly in Europe, solar cell modules are often set at an angle to the surface of the ground. Such a way of placement causes the solar cells to be exposed to ultraviolet rays reflected from the surface of the ground for a long period of time. Therefore, the outer layer side of a backside sealing sheet turns yellow, and the beauty of the appearance of the film is spoiled. Furthermore, in extreme cases, cracks or the like can occur in the backside sealing sheet, and there will be fears of degradation in properties of electric insulation, moisture barrier, and the like.

[Means of Solving the Problems]

To solve the problems, the present invention employs the following configuration. That is, the film for a backside sealing sheet of a solar cell of the present invention comprises a base film with at least one surface provided with a resin layer produced by copolymerizing an acrylic polyol resin with an ultraviolet absorbent and/or a light stabilizer combined with a resin layer that contains a conductive material, a coloring pigment, wherein the content of the conductive material is 5 to 20 mass% relative to the total mass of the resin layer, and the surface resistivity of the resin layer is $1.0 \times 10^9$ to $1.0 \times 10^{15}$ $\Omega$/square.

In addition, the backside sealing sheet of a solar cell of the present invention comprises the film for a backside sealing sheet of a solar cell of the present invention.

Furthermore, the solar cell module of the present invention comprises the backside sealing sheet of a solar cell of the present invention and a cell filler layer, where the backside sealing sheet of a solar cell and the cell filler layer are attached together.

[Advantageous Effects of Invention]

According to the present invention, a film for a backside sealing sheet of a solar cell which is excellent in partial discharge voltage as an indication for properties of light resistance and electrical insulation is obtained.

[Description of Embodiments]

The film for a backside sealing sheet of a solar cell of the present invention comprises a base film with at least one surface provided with a resin layer produced by copolymerizing an acrylic polyol resin with an ultraviolet absorbent and/or a light stabilizer combined with a resin layer that contains a conductive material, a coloring pigment wherein the content of the conductive material is 5 to 20mass% relative to the total mass of the resin layer, and the surface resistivity of the resin layer is $1.0 \times 10^9$ to $1.0 \times 10^{15}$ $\Omega$/square. Being structured as above, the film for a backside sealing sheet of a solar cell can be provided with excellent light resistance and high partial discharge voltage, compared with the conventional one.

[Base film]

Various resin films can be used as the substrate of the film for a backside sealing sheet of a solar cell. Specifically, the resin films include polyester resin films such as polyethylene terephthalate (PET) and polyethylene naphthalate (PEN); resin films such as those of polycarbonate, polymethyl methacrylate, polyacrylate, polypropylene, and polyethylene; and resin films made of mixtures of these resins. Among them, because of excellent strength, dimensional stability, and thermal stability, the polyester resin film is preferred. In terms of low cost, the polyester resins of PET, PEN, and the like are particularly preferred. Furthermore, the polyester resin may be a copolymer, and examples of a copolymerization component to be used include diol components such as propylene glycol, diethylene glycol, neopentyl glycol, and cyclohexane dimethanol, and dicarboxylic acid components such as isophthalic acid, adipic acid, azelaic acid, sebacic acid, and ester-forming derivatives. Furthermore, polyphenylene sulfide (PPS) having excellent hydrolysis resistance, heat resistance, and flame resistance can be also used. Furthermore, it is also possible to use fluorine-based films typified by polyvinyl fluoride conventionally used as a film for a backside sealing sheet.

Since the film for a backside sealing sheet of a solar cell is excellent in light resistance, in the configuration of a backside sealing sheet of a solar cell, the film can be preferably used for the outermost layer to be directly exposed to the outside air (humidity and temperature), and ultraviolet rays reflected from the surface of the ground. From the viewpoint of its use for the outermost layer, a preferred base film is one having excellent hydrolysis resistance. Usually, a polyester resin film is formed using as a raw material, so-called polymer, prepared by condensation polymerization of monomers, and contains about 1.5 to 2 mass% of oligomers that fall in between the monomer and the polymer. The representative oligomers are cyclic trimers. Films containing large amounts of such trimers suffer from a decrease in mechanical strength when being exposed to outdoor environmemt for a long period of time, and undergo cracks, material failures, and the like associated with progression of hydrolysis due to rainwater or the like. In contrast, the formation of a polyester film using as a raw material a polyester resin with a content of 1.0% or less of cyclic trimers, which is obtained by polymerization by a solid-phase polymerization process, prevents the film from hydrolysis at high temperature and high humidity. Thus, the film with more excellent heat resistance and weather resistance can be obtained. The determination of the above cyclic trimer content can be performed using, for example, a solution prepared by dissolving 100 mg of polymer in 2 ml of ortho-chlorophenol and performing liquid chromatography measure the content of the cyclic trimer (mass%) relative to the resin mass.

To the base film, if required, additives such as an antistatic agent, an ultraviolet absorbent, a stabilizer, an antioxidant, a plasticizer, a lubricant, a filler agent, and a coloring pigment may be added as long as the object of the present invention is not impaired.

The thickness of the base film is, but not specifically limited to, in the range of 1 to 250 $\mu$m in consideration of the voltage resistance, cost, and the like of the sealing sheet. The lower limit of the thickness is preferably 25 $\mu$m or more.

For providing moisture barrier property, the base film used may be a moisture barrier film in which at least one inorganic oxide layer is formed by a vapor deposition method or the like. The "moisture barrier film" in the present invention is a resin film having a moisture transmission rate of 5 g/(m$^2$·day) or less measured by method B described in JIS K7129 (2000 Edition). Because of stability, cost, and the like when the inorganic oxide layer is formed, the thickness of the above resin film is preferably in the range of 1 to 100 $\mu$m, more preferably in the range of 5 to 50 $\mu$m, and particularly preferably 10 to 30 $\mu$m for practical purposes.

The base film is preferably bi-axially extended so as to have good thermal dimensional stability. Furthermore, if required, the base film may be subjected to electric discharge treatment such as corona discharge or plasma discharge; or surface treatment such as an acid treatment; or the like.

[Resin layer]

The resin layer to be laminated to the base film of the present invention comprises (1) a resin prepared by copolymerization between an acrylic polyol resin and an ultraviolet absorbent and/or light stabilizer; (2) a conductive material; and (3) a coloring pigment. Generally, as a means for providing the resin layer with an ultraviolet-shielding performance to improve light resistance, an organic ultraviolet absorbent or an inorganic absorbent alone or a mixture of two or more different absorbents may be mixed in a binder resin, and may be used together with a light stabilizer (HALS) for increasing light stability through a mechanism of deactivating photo-excited radicals. However, a resin layer prepared by subsequent addition of the ultraviolet absorbent or the light stabilizer may cause the ultraviolet absorbent or the light stabilizer to bleed out of the coat film to the surface thereof at high temperature and high humidity or in association with ultraviolet light reception. Therefore, troubles such as loss of initially prominent ultraviolet-shielding performance tend to occur in addition to changes in wettability, the adhesion of the coat film surface, and the like. However, the present invention intends to solve the above problems by comprising polyester resin, olefin resin, and the like and using as a binder resin a resin prepared by copolymerizing an acrylic resin having comparatively excellent light resistance with an ultraviolet absorbent and/or a light stabilizer. Furthermore, among acrylic resins, an acrylic polyol resin is particularly preferred because of allowing a suitable cross-linking structure to be introduced into the resin layer to improve the adhesion between the base film and the resin layer or improve the heat resistance of the resin layer. The backside sealing sheet of a solar cell using a film for a backside sealing sheet of a solar cell is subjected to high temperature treatment in the process for manufacturing a solar cell module. Thus, the resin layer requires heat resistance.

For a comonomer for fixing the ultraviolet absorbent and/or the light stabilizer, a vinyl monomer such as an acrylic or styrenic vinyl monomer is preferred in terms of high flexibility and cost effectiveness. Since the styrenic vinyl monomer includes an aromatic ring, yellowing tends to occur, and the acrylic vinyl monomer is most preferred in terms of light resistance. Therefore, one polymerizable monomer component that constitutes the acrylic resin is one or more unsaturated hydrocarbons selected from the group consisting of unsaturated carboxylic acid esters, unsaturated carboxylic acids, unsaturated hydrocarbons, and vinyl esters.

Examples of the unsaturated carboxylic acid ester include methyl methacrylate, methyl acrylate, ethyl acrylate, ethyl methacrylate, n-propylacrylate, n-propyl methacrylate, isopropyl acrylate, isopropyl methacrylate, n-butyl acrylate, n-butyl methacrylate, isobutyl acrylate, isobutyl methacrylate, t-butyl acrylate, t-butyl methacrylate, 2-ethylhexyl acrylate, 2-ethylhexyl methacrylate, and the like.

The unsaturated carboxylic acids include acrylic acid, methacrylic acid, maleic acid, itaconic acid, crotonic acid, fumaric acid, and the like.

Said other monomers include butadiene, ethylene, vinyl acetate, and the like. The unsaturated carboxylic acid esters are preferred. Of the unsaturated carboxylic acid esters, methyl methacrylate and methyl acrylate are particularly preferred in terms of flexibility, cost, and light stability.

Described below is a polymerizable monomer to be used for preparing an acrylic polyol resin by introduction of a hydroxyl group as a nucleus point of a cross-linking structure, which is introduced for the purpose of improving the heat resistance of the resin layer. Examples of said polymerizable monomer component to be used for the purpose of providing an acrylic resin with a hydroxyl group include unsaturated compound monomers such as 2-hydroxyethyl acrylate, 2-hydroxyethyl methacrylate, 2-hydroxypropyl acrylate, 2-hydroxypropyl methacrylate, 2-hydroxybutyl acrylate, 2-hydroxybutyl methacrylate, 2-hydroxyvinyl ether, polyethylene glycol methacrylate, polypropylene glycol monoacrylate, and polypropylene glycol monomethacrylate. These unsaturated compounds having hydroxyl groups may be used independently or in combination of two or more thereof.

The thickness of the resin layer is preferably 0.2 to 5 $\mu$m. The lower limit of the thickness of the resin layer is more preferably 1 $\mu$m or more, particularly preferably 3 $\mu$m or more. The upper limit of the thickness of the resin layer is more preferably 4 $\mu$m or less. When the resin layer is formed by a coating technique, the resin layer of less than 0.2 $\mu$m in thickness tends to cause phenomena of eye holes and film cutting and the formation of a uniformly coat film becomes difficult. In some cases, therefore, adhesion to the base film and the ultraviolet-shielding performance may not be fully developed. On the other hand, if the thickness of the resin layer exceeds 5 $\mu$m, the ultraviolet-shielding performance can be developed sufficiently. However, there are concerns about restrictions to the coating method, increase in production costs, adhesion of the coat film to the transport roller, peeling of the coat film due to such adhesion, and the like.

The solvent of a coating solution for the formation of the resin layer, for instance, can be exemplified by toluene, xylene, ethyl acetate, butyl acetate, acetone, methyl ethyl ketone, methyl isobutyl ketone, tetrahydrofuran, dimethylformamide, dimethylacetamide, methanol, ethanol, water, and the like. Regarding the properties of the coating solution, it may be of an emulsion type or a dissolution type.

the method for forming the resin layer on the base film is not particularly limited, and any of known coating techniques can be used. As the coating technique, any of various methods can be applied including the roll coating method, the dip coating method, the bar coating method, the die coating method, the gravure roll coating method, or the like, or any of combinations thereof can be used. Of these, the gravure roll coating method is a preferred method because of increasing the stability of the resin layer.

[Ultraviolet absorbent]

Examples of the ultraviolet absorbent to be copolymerized with the above acrylic polyol resin include salicylic acid-based, beonzophenone-based, and cyanoacrylate-based ultraviolet absorbents. Specifically, examples can include salicylic acid-based ones such as p-t-butylphenyl salicylate, p-octylphenyl salicylate, benzophenone-based 2,4-dihydroxy benzophenone, 2-hydroxy-4-methoxy benzophenone, 2-hydroxy-4-methoxy-5-sulfobenzophenone, 2,2',4,4'-tetrahydroxy benzophenone, and bis(2-methoxy-4-hydroxy-5-benzoyl phenyl) methane; benzotriazol-based ones such as 2-(2'-hydroxy-5'-methylphenyl) benzotriazol, 2-(2'-hydroxy-5'-methylphenyl) benzotriazol, and 2,2'-methylenebis [4-(1,1,3,3-tetramethylbutyl)-6-(2H benzotriazol 2-yl) phenol]; cyanoacrylate-based ones such as ethyl-2-cyano-3,3'-diphenyl acrylate; others such as 2-(4,6-diphenyl-1,3,5-triazine 2-yl)-5-[(hexyl) oxy]-phenol; and their modified products, polymerized products, derivatives and the like.

[Light stabilizer]

Examples of the light stabilizer to be copolymerized with the above acrylic polyol resin include hindered amine-based light stabilizers. Specifically, it can be exemplified by bis(1,2,2,6,6-pentamethyl 4-piperidyl) [[3,5-bis(1,1-dimethylethyl)-4-hydroxyphenyl] methyl] butyl malonate, bis(1,2,2,6,6-pentamethyl 4-piperidyl) sebacate, methyl (1,2,2,6,6-pentamethyl 4-piperidyl) sebacate, decanedioic acid bis [2,2,6,6-tetramethyl 1-octyloxy]-4-piperidinyl] ester, and the like, and their modified products, polymerized products, derivatives and the like.

A process for manufacturing a copolymerization resin of a light stabilizer, an ultraviolet absorbent, and acrylic polyol is concretely disclosed in [0019] to [0039] of Japanese Unexamined Patent Application Publication (Kokai) No. 2002-90515. In particular, HALS-Hybrid resin (registered trademark) (manufactured by Nippon Shokubai Co., Ltd.) or the like, which contains a copolymerization product of an acrylic monomer and an ultraviolet absorbent, can be used as an effective component.

[Conductive materials (organic antistatic agents and inorganic solid conductive materials)]

Conductive materials of the present invention can be included for improving the partial discharge voltage of a film for a backside sealing sheet of a solar cell. As described above, one of the required properties of the backside sealing sheet of a solar cell is voltage resistance property, and one of product specifications thereof is a partial voltage discharge. For solar cell modules, selection and use of structural components depending on system voltages have been made mandatory. Solar-cell backside sealing sheets exhibiting higher partial discharge voltages can be extensively used for solar cell modules. Including the conductive material in the resin layer increases the partial discharge voltage of the film for a backside sealing sheet of a solar cell. The mechanism of an increase in the partial discharge voltage is unclear at present, but may be due to contribution of the film's surface potential equalized by imparted electric conductive property. To obtain an effect of increasing a partial discharge voltage, the surface of the resin layer has a surface resistance value of $1.0 \times 10^9$ to $1.0 \times 10^{15}$ $\Omega$/square. The lower limit of the surface resistance value is preferably $1.0 \times 10^{11}$ $\Omega$/square or more. The upper limit of the surface resistance value is preferably $1.0 \times 10^{14}$ $\Omega$/square or more.

If the surface resistance value is less than $1.0 \times 10^9$ $\Omega$/square, exposure to outdoor environment for a long period of time may bare the conductive material at the surface of the coat film due to deterioration/disappearance of the resin layer and in some cases it may lead to a surface resistance of less than $1.0 \times 10^7$ $\Omega$/square. In this case, electric conduction phenomenon may occur on the surface of the film. Thus, wet resistance, a property required for the backside sealing sheet of a solar cell, cannot be secured in some cases. On the other hand, if the surface resistance value exceeds $1.0 \times 10^{15}$ $\Omega$/square, the effect of increasing a partial discharge voltage may not be attained in some cases. This may be considered as a result of causing a partial discharge voltage without equalizing the surface potential of the film.

Furthermore, it is preferred that the resin layer has a surface resistance of $1.0 \times 10^7$ to $1.0 \times 10^{15}$ $\Omega$/square after ultraviolet irradiation under conditions of 60°C x 50% RH atmosphere, and an accumulated ultraviolet irradiation dose of 384 kWh/m$^2$.

In the case of using the film for a backside sealing sheet of a solar cell, ultraviolet irradiation causes deterioration/ disappearance of the resin layer and bares the conductive material at the surface of the coat film, and thus it may lead to a surface resistance of less than $1.0 \times 10^7$ $\Omega$/square. In this case, the surface of the film may cause electric conduction phenomenon. Therefore, in some cases, wet resistance, a property required for the backside sealing sheet of a solar cell, cannot be secured during use. To keep the surface resistance within a range of $1.0 \times 10^7$ to $1.0 \times 10^{15}$ even after ultraviolet irradiation, the surface resistance before the irradiation is preferably set in a range of $1.0 \times 10^9$ to $1.0 \times 10^{15}$. The lower limit of the surface resistance is more preferably less than $1.0 \times 10^{11}$.

The conductive material to be used may be an antistatic agent. Examples of the antistatic agent include non-ionic antistatic agents, for example, polyhydric alcohols such as ethylene glycol, diethylene glycol, triethylene glycol, glycerin, trimethylolpropane, pentaerythrite, and sorbit, and/or fatty acid esters thereof; polyethylene glycols and/or fatty acid esters thereof; polyethylene glycol adducts or polypropyrene glycol adducts of higher alcohols, polyhydric alcohols, and alkylphenols. Of these, the glycerine fatty acid esters, the polyethylene glycols, and/or the fatty acid esters thereof are preferably used as antistatic agents.

Polyhydric alcohols can be used without modification, but more preferably they should be used in the form of fatty acid esters by esterification reaction with fatty acids.

The fatty acids are not specifically limited. However, in terms of cost effectiveness, saturated fatty acids such as lauric acid (C12), palmitic acid (C16), stearic acid (C 18), and behenic acid (C22) and unsaturated fatty acids such as palmitoleic acid, oleic acid, erucic acid, and linoleic acid, and the like can be used. In addition, palm oil fatty acids, soybean oil fatty acids, beef tallow fatty acids, sardine oil fatty acids, and the like, and natural mixed fatty acids can be also used.

Furthermore, in the case of esterification of polyhydric alcohol with any of these fatty acids, it is preferred that at least one hydroxyl group per molecular structure of the polyhydric alcohol remains.

When using a polyethylene glycol and/or its fatty acid ester as an antistatic agent, the polyethylene glycol is preferably one having 4 to 1,000 ethylene oxide repeating units. In particular, it is preferably one having 100 to 8,000 ethylene oxide repeating units, and specifically preferably one having 1,000 to 6,000 ethylene oxide repeating units.

The polyethylene glycol can be directly used as an antistatic agent. However, in the case of subjecting it to fatty acid esterification, a terminal hydroxyl group may remain or may not remain.

In the case of using the polyethylene glycol adduct or polypropylene glycol adduct of a higher alcohol, the higher alcohol is not particularly limited as long as it has 6 or more carbons. However, the representative examples of the higher alcohol which are industrially easily available, include primary alcohols such as nonyl alcohol, decyl alcohol, lauryl alcohol, myristyl alcohol cetyl alcohol, stearyl alcohol, and oleyl alcohol. Alternatively, mixtures of sperm whale alcohol, jojoba alcohol, and the like and reduced alcohols of beef tallow alcohol, palm alcohol, and the like can be also be used.

When using the polyethylene glycol adduct or polypropylene glycol adduct of alkyl phenol as an antistatic agent, examples of the alkyl phenol include nonylphenol, dodecyl phenol, octyl phenol, and octyl cresol.

Furthermore, when using an ionic antistatic agent as an antistatic agent, examples of the ionic antistatic agent include anionic antistatic agents such as sulfonate-based antistatic agents, including alkyl sulfonate, alkylbenzene sulfonate, alkyl naphthalene sulfonate, and akyldiphenyl sulfonate, and phosphorus-containing antistatic agents, including alkyl phosphoric ester, alkyl phosphite, alkyl phosphonate, and alkyl phosphonate; cationic antistatic agents such as quaternary ammonium chloride, quaternary ammonium sulfate, and quaternary ammonium nitrate; and nonionic antistatic agents. Any of the ionic antistatic agents can be used, and examples of the anionic antistatic agents include, for example, Plysurf (registered trademark) M208F manufactured by Dai-Ichi Kogyo Seiyaku Co., Ltd., and Persoft (registered trademark) EDO and Persoft (registered trademark) EL manufactured by NOF Corporation. In addition, the commercial cationic antistatic agents include, for example, Nopcostat (registered trademark) SN A-2 manufactured by San Nopco Limited, Catiogen (registered trademark) ES-L supplied by Dai-Ichi Kogyo Seiyaku Co., Ltd., Elegan (registered trademark) 264WAX manufactured by NOF Corporation, Futargent (registered trademark) 310 manufactured by Neos Co., Ltd., and Elecond (registered trademark) PQ-50B manufactured by Soken Chemical & Engineering Co., Ltd. In addition, the nonionic antistatic agents include, for example, Noigen (registered trademark) TDS-30 and Noigen (registered trademark) ET-189 manufactured by Dai-Ichi Kogyo Seiyaku Co., Ltd.

Furthermore, the resin layer may be also provided with antistatic property by addition of a conductive polymer compound as an electrically conductive component. Examples of the conductive polymers include polyacetylene polymers, polypyrrole polymers, polythiophene polymers, polyaniline polymers, and the like.

The conductive materials to be used may be inorganic solid conductive materials such as conductive particles or fillers of carbon-based materials, metal-based materials, and the like to keep good partial discharge voltage and surface resistance even after ultraviolet irradiation. Such materials include carbon-based materials such as carbon black, graphite, fulleren, and carbon nanotube; and also include indium oxide, zinc oxide, tin oxide, potassium titanate, titanium oxide tin/antimony-based oxides, indium/tin-based oxides, antimony/tin-based oxides, and the like. Among them, at least one inorganic material selected from a group consisting of zinc oxide, titanium oxide, and potassium titanate is preferred. Furthermore, the use of titanium oxide covered with tin oxide is particularly preferred.

As an inorganic solid conductive material, the use of conductive fibers is preferred. Specifically, the conductive fibers have a number-average fiber diameter of about 0.1 to 1.0 $\mu$m, and a number-average fiber length of about 2 to 30 $\mu$m. In particular, needle-shaped crystal fibers of 5 to 15 $\mu$m in number-average fiber length are preferred. In addition, it may be of a rod-like shape; a needle-like shape with two sharp ends or with one sharp end; or a curved string-like shape. As a way of providing electric conductive property, the fiber itself may have electric conductive property or the surface of the fiber may be covered with a conductive material. As compared with a spherical, cubic, or plate-like shaped conductive material (hereinafter, referred to as a conductive material with a spherical shape or the like), the conductive fibers facilitate the materials to come in contact with each other when the same amount is added, Thus, if the same content is used, the partial discharge voltage obtained can be higher than one using a conductive material with a spherical shape or the like. Alternatively, since sufficient conductive networks can be formed with a smaller content, an equivalent or more partial discharge voltage can be obtained as compared with one using a conductive material with a spherical shape or the like. Furthermore, the use of conductive fibers can decrease the content of the conductive component in the resin layer. Thus, the resin obtained by copolymerization of the acrylic polyol resin and the ultraviolet absorbent and/or the light stabilizer can occupy a large part of the resin layer. Thus, a sufficient light resistance can be obtained, and both the partial discharge voltage and the light resistance can be achieved.

The conductive material is preferably an inorganic fiber with its surface covered by a conductive material. As described above, this is because the inorganic solid conductive material can keep an initial partial discharge voltage even after ultraviolet irradiation. Particularly preferable is a conductive material of needle-like crystal conductive material of 5 to 15 $\mu$m in number-average fiber length, prepared by covering titanium oxide with tin oxide. Such an inorganic fiber with its surface covered by a conductive material can be exemplified by a conductive ceramic material, Dentol (registered trademark) WK-500 manufactured by Otsuka Chemical Co., Ltd.

The content of an organic compound-based antistatic agent, an ionic antistatic agent, or an organic antistatic agent such as a conductive polymer compound, or the content of an inorganic solid conductive material is set so that the total of their contents is 5 to 20 mass% of the total mass of the resin layer even if each of them is added independently or added in combination with one or more others. The lower limit of the content is preferably 10 mass% or more. If the content is less than 5 mass%, the antistatic agent cannot fully form an electric conduction network, and electric conductive property may be hardly developed and become insufficient. On the other hand, if the content exceeds 20 mass%, the surface resistance value may become less than 1.0 x 10$^7$ $\Omega$/square. Thus, wet resistance, a property required for the backside sealing sheet of a solar cell, cannot be secured in some cases. In particular, the organic antistatic agent itself turns yellow by ultraviolet irradiation. Thus, if the content exceeds 20 mass%, deterioration in film appearance or decrease in partial discharge voltage may occur.

Of the various conductive material examples described above, cationic antistatic agents, such as quaternary ammonium chloride, quaternary ammonium sulfate, and quaternary ammonium nitrate, and inorganic solid conductive materials are preferably used from the viewpoint of moist heat resistance. In consideration of ultraviolet resistance in addition to moist heat resistance, inorganic solid conductive materials are particularly preferred.

Furthermore, the various conductive material examples described above may be used independently or may be used in combination of two or more.

[Coloring pigment]

Pigments used in the present invention are employed for the purpose of: (1) coring the resin layer; (2) maintaining a color tone (without color fading); (3) cutting ultraviolet rays and/or visual light; and (4) preventing a decrease in surface resistance. As the backside sealing sheet for a solar cell, a white sheet is mainly used in terms of light reflex and design properties. In recent years, however, compared with the above sheets that make the gaps between power-generating elements look white, the demand for black sheets has increased because of excellent design property.

In addition, the effect of protecting the base film from ultraviolet rays and/or visible light is acquired from these paints themselves absorbing and/or reflecting the light of a specific wavelength by coloring. Thus, by coloring, an effect of protecting the base film from ultraviolet rays and/or visual light can be achieved. Furthermore, by protecting the resin layer from ultraviolet rays, a deterioration/disappearance of the resin layer can be reduced even if exposed to outdoor environment over a long period of time. A decrease in surface resistance value due to the conductive material being bared at the surface of the coat film can be prevented, and wet resistance, a property required for the backside sealing sheet of a solar cell, can be secured. In addition, the backside sealing sheet of a solar cell is brought into contact with water (electrolytic solution) in a wet resistance test. However, by setting the surface resistance at a high value, an effect of preventing the resistance value from being lowered can be achieved even when in contact with water.

As a coloring pigment, any of various coloring pigments such as inorganic pigments and organic pigments can be used. With regard to white or black ones which are currently used, from the viewpoint of flexibility, price, coloring performance, and ultraviolet resistance, titanium oxide is preferred as a white pigment, and carbon black is preferred as a black pigment. Especially from the viewpoint of color development, the number average particle size of the titanium oxide is preferably 0.1 to 1.0 $\mu$m. From the viewpoint of dispersibility in the acrylic polyol resin and cost, it is more preferably 0.2 to 0.5 $\mu$m. Likewise, as for carbon black, the number average particle size thereof is preferably 0.01 to 0.5 $\mu$m. From the viewpoint of dispersibility or cost, it is more preferably 0.02 to 0.1 $\mu$m.

The content of the coloring pigment is preferably 40 to 70 mass% relative to the whole resin layer. The lower limit of the content is more preferably 45 mass%. The upper limit of the content is more preferably 55 mass%. If the content of the pigment is less than 40 mass%, ultraviolet and/or visible light shielding performance is insufficient. When exposed to outdoor environment over a long period of time, degradation of the base film and yellowing may occur. Furthermore, deterioration/disappearance of the resin layer may expose the conductive material at the surface of the coat film and cause a decrease in surface resistance value. On the other hand, if the content of the coloring pigment exceeds 70 mass%, chalking may occur on the surface of the resin layer due to an excess amount of a filler. In addition, if the content is too high, the hardness of the resin layer may increase extensively and cause insufficient adhesion to the base material. Furthermore, an excessive content causes an increase in cost.

[Cross-linking agent]

As described above, furthermore, for improving the properties of the resin layer, a cross-linking agent having a functional group reactive to a hydroxyl group of acryl polyol may be mixed in.

When a cross-linking agent is used together, an improved adhesion between the base film and the resin layer, or effects such as solvent resistance and heat resistance due to introduction of a cross-linking structure can be obtained. In particular, when a backside sealing sheet of a solar cell is designed so that the resin layer of the present invention is located on the outermost layer, the resin layer is subjected to thermal treatment at a high temperature of up to about 150°C for 30 minutes or more in the process for manufacturing a solar cell module, particularly a process for glass lamination (cell-packing process). Thus, a high heat resistance is specifically required. In the process for manufacturing a solar cell module, furthermore, there is a wiping step using ethanol or other organic solvents during cleaning after module assembly. Thus, solvent resistance is requested. From the viewpoint of improvement in such adhesiveness, solvent resistance, and heat resistance, it is preferred to add a cross-linking agent. On the other hand, if any cross-linking agent is not mixed, the number of hydroxyl groups of acryl polyol on the surface of the coat film increases, causing an increase in partial discharge voltage. Therefore, whether to add a cross-linking agent based on consideration of the balance among the improvement in partial discharge voltage and the improvement in adhesiveness, solvent resistance, and heat resistance. Although it would be impossible to conclude categorically, when a conductive material having a spherical shape or the like is used as a conductive material, mixing in a cross-linking agent is preferably avoided for attaining a partial discharge voltage required for a film for a backside sealing sheet of a solar cell. On the other hand, when a conductive fiber is used as a conductive material, a sufficient partial discharge voltage required for a film for a backside sealing sheet of a solar cell can be attained even if a cross-linking agent is mixed despite the use of the cross-linking agent can lead to a decrease in partial discharge voltage.

Since the present invention uses a resin obtained by copolymerization of the acrylic polyol resin with an ultraviolet absorbent and/or a light stabilizer, a cross-linking agent reactive to the hydroxyl group in the resin can be used. In particular, a preferred formulation is one using a polyisocyanate resin as a curing agent and facilitating the generation of a urethane bond (cross-linked structure). Examples of the polyisocyanate resin used as a cross-linking agent include aromatic polyisocyanate, aromatic aliphatic polyisocyanate, alicyclic polyisocyanate, and aliphatic polyisocyanate. Each of them is a resin using as a raw material a diisocyanate compound described below. These may be used independently or may be used in combination of two or more thereof.

Examples of diisocyanate to be used as a raw material of the aromatic polyisocyante include m- or p-phenylene diisocyanate, 4,4'-diphenyl diisocyanate,1,5-naphthalene diisocyanate (NDI), 4,4'-, 2,4'-or 2,2'-diphenylmethane diisocyanate (MDI), 2,4- or 2, 6-tolylene diisocyanate (TDI), and 4,4'-diphenyletherdiisocyanate.

Examples of diisocyanate to be used as a raw material of the aromatic aliphatic polyisocyante include 1,3- or 1,4-xylylene diisocyanate (XDI), and 1,3- or 1,4-tetramethyl xylylene diisocyanate (TMXDI).

Examples of diisocyanate to be used as a raw material of the alicyclic polyisocyanate include 1,4-cyclohexane diisocyanate, 1,3-cyclohexane diisocyanate, 3-isocyanate methyl-3,5,5-trimethyl cyclohexyl isocyanate (isophorone diisocyanate; IPDI), 4,4'-, 2,4'- or 2,2'-dicyclohexylmethane diisocyanate (hydrogenated MDI), methyl-2,4-cyclohexane diisocyanate, methyl-2,6-cyclohexane diisocyanate, and 1,3- or 1,4- bis(isocyanate methyl) cyclohexane (hydrogenated XDI).

Examples diisocyanate to be used as a raw material of the aliphatic polyisocyanate include trimethylene diisocyanate, tetramethylene diisocyanate, hexamethylene diisocyanate (HDI), pentamethylene diisocyanate, 1,2-propylene diisocyanate, 1,2-, 2,3-, or 1,3- butylene diisocyanate, and 2,4,4- or 2,2,4-trimethyl hexamethylene diisocyanate.

As a raw material of the polyisocyanate, two or more of these diisocyanates may be combined and used, or may be used as a modified product such as a biuret-modified product or a nurate-modified product. Particularly, as a raw material of the polyisocyanate, it is preferred to use a curing agent containing alicyclic polyisocyanate and/or aliphatic polyisocyanate as the main component because any resin with a skeleton containing an aromatic ring having a light absorption band in the ultraviolet region is easily yellowed when irradiated with ultraviolet rays. Furthermore, it is preferred to use alicyclic polyisocyanate that allows the resin layer to be cured more rapidly from the view point of solvent resistance. In addition, a nurate-modified product of hexamethylene diisocyanate is preferred from the view point of progressability, degree of cross-linking, heat resistance, and ultraviolet resistance.

[Adhesive layer]

A backside sealing sheet of a solar cell can be obtained by lamination of a film for a backside sealing sheet of a solar cell and other resin films. A known dry lamination process can be used as a technique for laminating these films and processing them into a sheet-like shape. To bond resin films using the dry lamination process, a known dry lamination adhesive can be used. The adhesive contains a base resin, such as a polyether polyurethane, polyester polyurethane, polyester, or polyepoxy resin, and a polyisocyanate resin as a curing agent. The adhesive layer formed using any of these adhesives, however, should not suffer delamination as a result of deterioration in the adhesive strength attributed to long term outdoor use, or undergo yellowing that leads to a decrease in light reflectance. The adhesive layer preferably has a thickness in the range of 1 to 5 $\mu$m. An adequate adhesive strength may not be achieved if it is less than 1 $\mu$m. If it exceeds 5 $\mu$m, on the other hand, there are possibilities that adhesive application speed will not be increased; a long aging time will be required for the purpose of developing an adhesive strength (to accelerate the cross-linking reaction between the base resin and the curing agent); and the amount of the adhesive will be increased.

A known adhesive for dry lamination can be used as a material to be used in the formation of an adhesive layer. A common adhesive for dry lamination consists of two resins, a base resin and a cross-linking agent, diluted and formulated in a diluent solvent. The cross-linking agent to be used is preferably a polymer containing an isocyanate group, which may be high in reactivity with active hydroxyl groups and also high in reaction rate and can develop an initial contact strength quickly. In addition to these advantages, it serves to form an adhesive resin layer that is high in the adhesive strength to the base film, and shows the stability of adhesive strength at constant temperatures and excellent durability for a long period of time. The base resin to be used in combination with this polymer containing an isocyanate group may be, for instance, a polyether-, polyester-, or polyol-based urethane resin or an epoxy resin, and an appropriate one may be selected to meet the detailed required characteristics and processing conditions. Furthermore, depending on the constitution of the solar-cell backside sealing sheet, it is likely that ultraviolet rays can reach the adhesive layer to cause photo-degradation of the resin. From this viewpoint, the resin to be used to form the adhesive layer is preferably an aliphatic resin or an alicyclic resin in which aromatic rings do not exist or account for a very small part.

[Solar-cell backside sealing sheet]

The solar-cell backside sealing sheet using a film for a backside sealing sheet of a solar cell will be described below. The solar-cell backside sealing sheet is required to have various properties typified by, for example, moisture barrier, light reflectivity, long term moist heat resistance and light resistance, high adhesion to cell fillers, and electric insulation. To meet these required characteristics, efforts are being made in the industrial sector to provide various sheet designs (laminate designs) that combine different functional films with processing techniques such as deposition and wet coating, based on the concept of functional partition.

Backside sealing sheets of a solar cell which satisfy various required properties can be produced by lamination of one or more films selected from the group of a hydrolysis resistant film, a white film, a film with a deposited inorganic oxide layer, and a film that heat-bonds to EVA, but different from the base film, on the film for a backside sealing sheet of a solar cell of the present invention. In particular, it is preferred that the solar-cell backside sealing sheet which forms the outermost face when built in a solar cell module is composed of a hydrolysis resistant film as a base film and a film for a backside sealing sheet of a solar cell added on the base film. The use of a hydrolysis resistant film serves to prevent the inner layers (adhesive layer, film layer, etc.) which are located under the hydrolysis resistant film, from being hydrolyzed. In addition, since a resin layer having ultraviolet and/or visible light shielding performance is located on the outermost side, the inner under the resin layer can be protected from ultraviolet rays and/or visible light. On the other hand, it is preferred that one or more films selected from the group of a white film, a film with a deposited inorganic oxide layer, and a film that can heat-bonds to EVA is provided on the opposite side of the base film to the resin layer-laminated side. Light reflectivity is provided when a white film is laminated, and moisture barrier property is provided when a film with a deposited inorganic oxide layer is laminated. And adhesiveness to a cell filler layer is provided when a film that can heat-bonds to EVA is laminated. Said film to be added on the film for a backside sealing sheet of a solar cell of the present invention may not always be a single uniform film. A solar-cell backside sealing sheet may be designed so that different component films are combined into one depending on the intended properties.

In its constitution, the solar-cell backside sealing sheet may contain a deposited layer, sputtered layer, wet coating layer, and the like for the purpose of imparting functionalities, at any position of any layer other than on the resin layer of the invention.

The following methods are exemplary ones for manufacturing a film for a backside sealing sheet of a solar cell. As a base film, for example, a hydrolysis resistant polyethylene terephthalate film, such as Lumiror (registered trademark) X10S manufactured by Toray Industries, Inc., is prepared. Then, a coating material is prepared by mixing a main resin consisting of an acrylic polyol resin, a conductive material and a coloring pigment dispersed and mixed using a bead mill, with a nurate type hexamethylene diisocyanate resin as a cross-linking agent, and a solvent. The base film is coated with the coating material by gravure coating to obtain a film for a backside sealing sheet of a solar cell. Furthermore, a solar-cell backside sealing sheet is obtained by forming by dry lamination at least one film selected from the group of a white film, a film with a deposited inorganic oxide layer, and a film that can heat-bonds to an ethylene/vinyl acetate copolymer on the opposite side to the resin layer-laminated side of the film for a backside sealing sheet of a solar cell.

[Examples]

Next, the film for solar-cell backside sealing sheet of the present invention and the solar-cell backside sealing sheet formed thereof will be described concretely with reference to Examples.

<Methods for characteristics evaluation>

The methods used for characteristics evaluation for the invention are as described below.

(1) Measurement of coating amount

A film for a backside sealing sheet of a solar cell was cut into test pieces with an area of 500 cm$^2$ after resin layer formation, and the mass of each test piece, referred to as mass (1) [g], was measured. Next, from the test piece, the resin layer was dissolved and removed in methyl ethyl ketone, and the mass of the test piece was measured again and referred to as mass (2) [g]. Subsequently, the coating amount per unit area was calculated based on the following equation. Coating amount measurements were made for three test pieces, and their average was determined to represent their coating amount.

$$\cdot \text{ Coating amount } [g/m^2] = \{(\text{mass } (1)) - (\text{mass } (2))\} \times 20.$$

(2) Evaluation for solvent resistance

A sample was immersed in ethanol for 5 minutes, and subsequently rubbed 50 times with Kimwipe. Then, a partial discharge voltage was measured in a manner similar to the following item (7). The appearance of the coat film was visually observed and classified as follows.

A: No change found in the state of the coat film compared with untreated sample.
B: Peeling found between the base material and the coat film.

(3) Measurement of moisture transmission rate

Measurement of a moisture transmission rate was performed according to the B method (infrared sensing method) described in JIS K7129 (2000) under the conditions of a temperature of 40°C and a humidity of 90%RH. A measurement apparatus used was Permatran (registered trademark) W3/31, a device for measuring a moisture transmission rate, manufactured by MOCON, Inc., U.S.A. A measurement of moisture transmission rate was made once for each of two test pieces, and the average of two measurement values was determined to represent their moisture transmission rate.

(4) Evaluation for ultraviolet-shielding performance (spectroscopic measurement)

The spectroscopic spectrum was measured based on JIS K 7105 (version in the 2006 fiscal year). A measurement apparatus used was UV-Vis-NIR spectrophotometer UV-3150 manufactured by Shimadzu Corporation. The ultraviolet-shielding performance of the film for a backside sealing sheet of a solar cell was evaluated by the measurement of a light transmission rate at a wavelength of 360 nm.

(5) Evaluation for strength of contact between base film and resin layer

To evaluate the strength of contact (coat layer contact strength) between the base film and the resin layer in a film for solar-cell backside sealing sheet prepared, a crosscut test according to the method described in JIS K 5400 (1990) was performed. The result was classified as follows.

AA: 100 out of 100 squares remaining.
A: 81 to 99 out of 100 squares remaining.
B: 80 or less out of 100 squares remaining.

(6) Measurement of surface resistance value

The surface resistance value of the resin layer was measured in an environment of 23°C and 65%RH. For samples on which the resin layer was not formed, measurements were made with a probe electrode held in contact with the base film surface. Measurements were made on three test pieces. The average of measured values was determined to represent the surface resistance value. A measurement apparatus used was a surface resistivity meter MCP-HT450 manufactured by Mitsubishi Chemical Corporation.

(7) Measurement of partial discharge voltage

The partial discharge voltage was measured in an environment of 23°C and 65%RH. A measurement apparatus used was a partial discharge tester KPD2050 manufactured by Kikusui Electronics Corp. For samples on which resin layers were formed, measurements were made with a voltage applied to the surface of the resin layer. For samples free of a resin layer, measurements were made with a voltage applied to the base film surface. A measurement was made once for each of ten test pieces, and collected ten pieces of data in total. The average of measured values was determined to represent their partial discharge voltage.

(8) Evaluation for ultraviolet resistance

Ultraviolet irradiation with a strength of 160 mW/cm$^2$ was performed under 60°C x 50% RH atmosphere for 240 hours. A measurement apparatus used was Eye Super UV Tester SUV-W151 manufactured by Iwasaki Electric Co., Ltd. The b-value in the color system was measured before and after the irradiation. Ultraviolet irradiation was performed similarly for evaluation of ultraviolet-shielding performance, evaluation of adhesion strength between the base film and the resin layer, and evaluation of surface resistance before and after the irradiation for the purpose of evaluating the ultraviolet resistance of these properties.

(9) Evaluation for moist heat resistance

Test pieces of the film for solar-cell backside sealing sheet were heat-treated for 48 hours in an environment of 120°C and 100% RH. A test apparatus uses was a pressure cooker TPS-211 manufactured by Espec Corp. Subsequently, the films for solar-cell backside sealing sheet were subjected to evaluation of ultraviolet-shielding performance, evaluation of the adhesion strength between the base film and the resin layer, and evaluation of surface resistance for the purpose of evaluating the moist heat resistance of these properties.

 (10) Light reflectance

An EVA sheet was added to the inner side (opposite side of the base film to the resin layer-laminated surface of the base film) of the solar-cell backside sealing sheet and semi-reinforced glass of 0.3 mm in thickness was then added thereon. Subsequently, after vacuuming it using a commercially available glass laminator, pseudo solar cell module samples were prepared by pressing for 15 minutes under a load of 3 Kgf/cm$^2$ under the conditions of heating at 135°C. The EVA sheet used was a 500-μm thickness sheet manufactured by Sanvic Inc.
Light was applied to the glass side of the pseudo solar cell module sample, and the light reflectance of the inner side of the backside sealing sheet (opposite side to the resin layer-laminated surface of the base film) was measured. As measured values of the reflectance, those determined at a wavelength of 600 nm was used to represent them. The measurement apparatus used was a spectrophotometer MPC-3100 manufactured by Shimadzu Corporation.

(11) Measurement of adhesive strength to filler (EVA adhesion)

Pseudo solar cell module samples were prepared in a manner similar to the above item (10). Using the pseudo solar cell modules, the adhesive strength to EVA sheets was measured according to JIS K 6854-2 (1999). Test pieces of 10 mm in width were used for the adhesive strength test, and each of two test pieces was measured once. The average of two measured values was determined to represent their adhesive strength. An adhesive strength of 100 N/50 mm or more was assumed to be practically acceptable.

(12) Measurement of wet insulation resistance

Pseudo solar cell module samples were prepared in a manner similar to the above item (10). Using the pseudo solar cell modules, wet insulation resistance was measured according to IEC61215 10.15. The module was dipped in an electrolytic solution, the terminal of a testing machine was brought into contact with the electrolytic solution. Then, a leak current was measured by application of a voltage of 500 V. A required insulation resistance was 400 MΩ or more when the solar cell module had an area of 0.1 m$^2$ or less, and 40 MΩ or more when 0.1 m$^2$ or more.

(13) Evaluation for chalking resistance

Films on which a resin layer was formed were subjected to aging for three days in an environment of 40°C. The surface of the resin layer after aging was observed and classified as follows.

A: Chalking did not occur in the coating film.
B: Chalking occurred in the coating film.

(Preparation of paint 1 for resin layer formation)

As an acrylic resin, HALS Hybrid Polymer (registered trademark) BK1 (solid content of 40 mass%, referred to as acrylic resin 1) manufactured by Nippon Shokubai Co., Ltd., where an ultraviolet absorbent and a photo-stabilizing agent (HALS) were cross-linked to an acrylic polyol resin, was prepared. Acrylic resin 1, a conductive material, a coloring pigment, and a solvent were mixed in their respective amounts represented in Table 1, and then dispersed using a bead mill. Thus, a base paint having a solid concentration of 50 mass% was obtained. The conductive material and the coloring pigment used were products described below.
Conductive material: Inorganic solid conductive material which is needle-like crystals prepared by coating titanium oxide with tin oxide. The number average fiber length is distributed in the range of 5 to 15 μm.
White pigment: Titanium oxide particles JR-709 manufactured by Tayca Corporation.
Black paint: Carbon black particles Special Black 4A manufactured by Degussa Corporation.
The base paint was mixed with a nurate-type hexamethylene diisocyanate resin, Desmodur (registered trademark) N3300 (solid concentration: 100 mass%) manufactured by Sumitomo Bayer Urethane Co., Ltd., so as to adjust the mass ratio of base paint/nurate-type hexamethylene diisocyanate resin = 100/4. Furthermore, n-propyl acetate was added as diluent and stirred for 15 minutes to provide a paint having a solid concentration of 20 mass% (resin solid concentration). In this way, paint 1 for resin layer formation with a solid concentration (solid resin concentration) of 20 mass% was obtained.

(Preparation of paint 2 for resin layer formation)

Paint 2 for resin layer formation prepared in a manner similar to the preparation of paint 1 for resin layer formation, except that the mixing amount was set as represented in Table 1 so that the conductive material would have a 19 mass% content relative to the resin solid content.

(Preparation of paint 3 for resin layer formation)

Paint 3 for resin layer formation was prepared in a manner similar to the preparation of paint 1 for resin layer formation, except that the mixing amount was set as represented in Table 1 so that the conductive material would have a 6 mass% content relative to the resin solid content.

(Preparation of paint 4 for resin layer formation)

Paint 4 for resin layer formation was prepared in a manner similar to the preparation of paint 1 for resin layer formation, except that cationic antistatic agent, Elecond (registered trademark) PQ-50B manufactured by Soken Chemical & Engineering Co., Ltd., was added instead of the inorganic solid conductive material.

(Preparation of paint 5 for resin layer formation)

Paint 5 for resin layer formation was prepared in a manner similar to the preparation of paint 1 for resin layer formation, except that the mixing amount was set as represented in Table 1 so that the coloring pigment would have a 40 mass% content relative to the resin solid content.

(Preparation of paint 6 for resin layer formation)

Paint 6 for resin layer formation was prepared in a manner similar to the preparation of paint 1 for resin layer formation, except that the mixing amount was set as represented in Table 1 so that the coloring pigment would have a 70 mass% content relative to the resin solid content.

(Preparation of paint 7 for resin layer formation)

Paint 7 for resin layer formation was prepared in a manner similar to the preparation of paint 1 for resin layer formation, except that the mixing amount was set as represented in Table 1 so that the coloring pigment would have a 35 mass% content relative to the resin solid content.

(Preparation of paint 8 for resin layer formation)

Paint 8 for resin layer formation was prepared in a manner similar to the preparation of paint 1 for resin layer formation, except that the mixing amount was set as represented in Table 1 so that the coloring pigment would have a 75 mass% content relative to the resin solid content.

(Preparation of paint 9 for resin layer formation)

Paint 9 for resin layer formation was prepared in a manner similar to the preparation of paint 1 for resin layer formation, except that a biuret-type hexamethylene diisocyanate resin, Desmodur (registered trademark) N3200 (solids concentration: 100 mass%), was used instead of the nurate-type hexamethylene diisocyanate resin.

(Preparation of paint 10 for resin layer formation)

Paint 10 for resin layer formation was prepared in a manner similar to the preparation of paint 1 for resin layer formation, except that the mixing amount was set as represented in Table 2 so that the conductive material would have a 4 mass% content the relative to the resin solid content.

(Preparation of paint 11 for resin layer formation)

Paint 11 for resin layer formation was prepared in a manner similar to the preparation of paint 1 for resin layer formation, except that the mixing amount was set as represented in Table 2 so that the conductive material would have a 25 mass% content relative to the resin solid content.

(Preparation of paint 12 for resin layer formation)

Paint 12 for resin layer formation was prepared in a manner similar to the preparation of paint 1 for resin layer formation, except that the conductive material was not mixed and the mixing amount represented in Table 2 was used.

(Preparation of paint 13 for resin layer formation)

Paint 13 for resin layer formation was prepared in a manner similar to the preparation of paint 1 for resin layer formation, except that the conductive material was not mixed and the mixing amount represented in Table 2 was used.

(Preparation of paint 14 for resin layer formation)

As acrylic resin, a resin (solid concentration: 40 mass%, referred to as acrylic resin 2) was prepared by post-addition of an ultraviolet absorbent and a light stabilizer (HALS) to an acrylic resin prepared from methyl methacrylic acid and 2-hydroxyethyl methacrylate as raw materials without carrying out crosslinking. Paint 14 for resin layer formation was prepared in a manner similar to the preparation of pain 1 for resin layer formation, except that the acrylic resin 2 was used instead of HALS Hybrid Polymer (registered trademark) BK1 (solid concentration: 40 mass%).

[Table 1]

| | | | Paint 1 | Paint 2 | Paint 3 | Paint 4 | Paint 5 | Paint 6 | Paint 7 | Paint 8 | Paint 9 |
|---|---|---|---|---|---|---|---|---|---|---|---|
| Composition of base resin | Acrylic resin 1 *1 | parts by mass | 35.0 | 33.0 | 40.0 | 35.0 | 45.0 | 25.0 | 50.0 | 20.0 | 35.0 |
| | Acrylic resin 2 *2 | parts by mass | 0.0 | 0.0 | 0.0 | 0.0 | 0.0 | 0.0 | 0.0 | 0.0 | 0.0 |
| | Dentol (registered trademark) WK-500 manufactured by Otsuka Chemical Co., Ltd. *3 | parts by mass | 15.0 | 19.0 | 6.0 | 0.0 | 15.0 | 5.0 | 15.0 | 5.0 | 15.0 |
| | Cationic antistatic agent *4 | parts by mass | 0.0 | 0.0 | 0.0 | 15.0 | 0.0 | 0.0 | 0.0 | 0.0 | 0.0 |
| | Coloring pigment | parts by mass | 50.0 | 48.0 | 54.0 | 50.0 | 40.0 | 70.0 | 35.0 | 75.0 | 50.0 |
| | Ethyl acetate | parts by mass | 100.0 | 100.0 | 100.0 | 100.0 | 100.0 | 100.0 | 100.0 | 100.0 | 100.0 |
| | Solid paint content in base resin | mass% | 50.0 | 50.0 | 50.0 | 50.0 | 50.0 | 50.0 | 50.0 | 50.0 | 50.0 |
| Curing agent | Isocyanate 1 *5 | parts by mass | 8.0 | 8.0 | 8.0 | 8.0 | 8.0 | 8.0 | 8.0 | 8.0 | 0.0 |
| | Isocyanate 2 *6 | parts by mass | 0.0 | 0.0 | 0.0 | 0.0 | 0.0 | 0.0 | 0.0 | 0.0 | 8.0 |
| Diluent | n-propyl acetate | parts by mass | 332.0 | 332.0 | 332.0 | 332.0 | 332.0 | 332.0 | 332.0 | 332.0 | 332.0 |
| Solid content in prepared paint | | mass% | 20.0 | 20.0 | 20.0 | 20.0 | 20.0 | 20.0 | 20.0 | 20.0 | 20.0 |

*1 HALS Hybrid Polymer (registered trademark) BK1 manufactured by Nippon Shokubai Co., Ltd., composed of acrylic polyol resin cross-linked with ultraviolet absorbent and photostabilizing agent.

*2 Composed of acrylic polyol resin, ultraviolet absorbent and photo-stabilizing agent that are contained together but not cross-linked.

*3 Inorganic solid conductive material which is needle-like crystal of titanium oxide coated with tin oxide and has a number-average fiber length of 5 to 15 $\mu$m.

*4 Elecond (registered trademark) PQ-50B manufactured by Soken Chemical & Engineering Co., Ltd.

*5 Nurate-type hexamethylene diisocyanate resin, Desmodur (registered trademark) N3300 (solid content: 100 mass%) manufactured by Sumitomo Bayer Urethane Co., Ltd.

*6 Biuret-type hexamethylene diisocyanate resin, Desmodur (registered trademark) N3200 manufactured by Sumitomo Bayer Urethane Co., Ltd.

[Table 2]

| | | | Paint 10 | Paint 11 | Paint 12 | Paint 13 | Paint 14 |
|---|---|---|---|---|---|---|---|
| Composition of base resin | Acrylic resin 1 * 1 | parts by mass | 39.0 | 30.0 | 40.0 | 85.0 | 0.0 |
| | Acrylic resin 2 *2 | parts by mass | 0.0 | 0.0 | 0.0 | 0.0 | 35.0 |
| | Dentol (registered trademark) WK-500 manufactured by Otsuka Chemical Co., Ltd. *3 | parts by mass | 4.0 | 25.0 | 0.0 | 15.0 | 15.0 |
| | Cationic antistatic agent *4 | parts by mass | 0.0 | 0.0 | 0.0 | 0.0 | 0.0 |
| | Coloring pigment | parts by mass | 57.0 | 45.0 | 60.0 | 0.0 | 50.0 |
| | Ethyl acetate | parts by mass | 100.0 | 100.0 | 100.0 | 100.0 | 100.0 |
| | Solid paint concentration in base resin | mass% | 50.0 | 50.0 | 50.0 | 50.0 | 50.0 |
| Curing agent | Isocyanate 1 *5 | parts by mass | 8.0 | 8.0 | 8.0 | 8.0 | 8.0 |
| | Isocyanate 2 *6 | parts by mass | 0.0 | 0.0 | 0.0 | 0.0 | 0.0 |
| Diluent | n-propyl acetate | parts by mass | 332.0 | 332.0 | 332.0 | 332.0 | 332.0 |
| Solid concentration of formulated paint | | mass% | 20.0 | 20.0 | 20.0 | 20.0 | 20.0 |

* HALS Hybrid Polymer (registered trademark) BK1 manufactured by Nippon Shokubai Co., Ltd., composed of acrylic polyol resin cross-linked with ultraviolet absorbent and photostabilizing agent.
*2 Composed of acrylic polyol resin, ultraviolet absorbent and photo-stabilizing agent that are contained together but not cross-linked.
*3 Inorganic solid conductive material which is needle-like crystal of titanium oxide coated with tin oxide and has a number-average fiber length of 5 to 15 μm.
*4 Elecond (registered trademark) PQ-50B manufactured by Soken Chemical & Engineering Co., Ltd.
*5 Nurate-type hexamethylene diisocyanate resin, Desmodur (registered trademark) N3300 (solid content: 100 mass%) manufactured by Sumitomo Bayer Urethane Co., Ltd.
*6 Biuret-type hexamethylene diisocyanate resin, Desmodur (registered trademark) N3200 manufactured by Sumitomo Bayer Urethane Co., Ltd.

(Preparation of adhesive for dry lamination)

Sixteen parts by mass of a dry lamination agent Dicdry (registered trademark) LX-903 manufactured by DIC Corporation), 2 parts by mass of a curing agent KL-75 supplied by Dainippon Ink and Chemicals, Inc., and 29.5 parts by mass of ethyl acetate were weighed out and stirred for 15 minutes. In this way, a dry lamination adhesive having a solid concentration of 20% was obtained.

(Preparation of paint for adhesion layer formation)

Twelve part by mass of a dry lamination agent Takelac (registered trademark) A-310 (polyester polyurethane resin) manufactured by Mitsui Chemicals Polyurethanes, Inc., 1 part by mass of an aromatic polyisocyanate resin (Takenate (registered trademark) A-3 supplied by Mitsui Chemicals Polyurethanes, Inc.), and 212 parts by mass of ethyl acetate were weighed out and stirred for 15 minutes. In this way, a paint for adhesion layer formation with a solid content of 3 mass% was obtained.

(Preparation of paint for heat-bonding resin layer formation)

Twenty parts by mass of an aqueous emulsion paint containing EVA type ternary copolymer resin (Aquatex (registered trademark) MC-3800 supplied by CSC Co., Ltd.), 10.8 parts by mass of isopropyl alcohol, and 22.6 parts by mass of water was weighed out and stirred for 15 minutes. In this way, a paint for heat-bonding resin layer formation with a solid content of 15 mass% was obtained.

(Example 1)

As a base film, a hydrolysis resistant polyethylene terephthalate film with a trimer content of 1 mass% or less, Lumirror(TM) (registered trademark) X10S (125 $\mu$m) manufactured by Toray Industries, Inc., was prepared. Paint 1 for coat layer formation was applied with a wire bar over one side of this base film and dried at 120°C for 30 seconds to form a resin layer having a coating amount of 4.0 g/m$^2$ after drying. Thus, film 1 for solar-cell backside sealing sheet was produced.

(Example 2)

Film 2 for a backside sealing sheet of a solar cell was produced in a manner similar to the method described in Example 1, except that the paint 2 for resin layer formation was applied instead of the paint 1 for resin layer formation.

(Example 3)

Film 3 for a backside sealing sheet of a solar cell was produced in a manner similar to the method described in Example 1, except that the paint 3 for resin layer formation was applied instead of the paint 1 for resin layer formation.

(Example 4)

Film 4 for a backside sealing sheet of a solar cell was produced in a manner similar to the method described in Example 1, except that the paint 4 for resin layer formation was applied instead of the paint 1 for resin layer formation.

(Example 5)

Film 5 for a backside sealing sheet of a solar cell was produced in a manner similar to the method described in Example 1, except that the paint 5 for resin layer formation was applied instead of the paint 1 for resin layer formation.

(Example 6)

Film 6 for a backside sealing sheet of a solar cell was produced in a manner similar to the method described in Example 1, except that the paint 6 for resin layer formation was applied instead of the paint 1 for resin layer formation.

(Example 7)

Film 7 for a backside sealing sheet of a solar cell was produced in a manner similar to the method described in Example 1, except that the paint 7 for resin layer formation was applied instead of the paint 1 for resin layer formation.

(Example 8)

Film 8 for a backside sealing sheet of a solar cell was produced in a manner similar to the method described in Example 1, except that the paint 8 for resin layer formation was applied instead of the paint 1 for resin layer formation.

(Example 9)

Film 9 for a backside sealing sheet of a solar cell was produced in a manner similar to the method described in Example 1, except that the paint 9 for resin layer formation was applied instead of the paint 1 for resin layer formation.

(Comparative Example 1)

Film 10 for a backside sealing sheet of a solar cell was produced in a manner similar to the method described in Example 1, except that the paint 10 for resin layer formation was applied instead of the paint 1 for resin layer formation.

(Comparative Example 2)

Film 11 for a backside sealing sheet of a solar cell was produced in a manner similar to the method described in Example 1, except that the paint 11 for resin layer formation was applied instead of the paint 1 for resin layer formation.

(Comparative Example 3)

Film 12 for a backside sealing sheet of a solar cell was produced in a manner similar to the method described in Example 1, except that the paint 12 for resin layer formation was applied instead of the paint 1 for resin layer formation.

(Comparative Example 4)

Film 13 for a backside sealing sheet of a solar cell was produced in a manner similar to the method described in Example 1, except that the paint 13 for resin layer formation was applied instead of the paint 1 for resin layer formation.

(Comparative Example 5)

Film 14 for a backside sealing sheet of a solar cell was produced in a manner similar to the method described in Example 1, except that the paint 14 for resin layer formation was applied instead of the paint 1 for resin layer formation.

(Comparative Example 6)

Lumiror (registered trademark) X10S (manufactured by Toray Industries, Inc., 125 $\mu$m) was used as film 15 for a backside sealing sheet of a solar cell without forming a resin layer.
Properties were evaluated by the above evaluation methods using films for solar-cell backside sealing sheet of Examples 1 to 9 and Comparative Examples 1 to 6 obtained above. Results are illustrated in Tables 3 and 4.
[Table 3]

| | Film for backside sealing sheet of solar cell | Resin layer | | Solvent resistance (Visual observation) | Chalking resistance | Adhesion between base material and resin layer | | | UV-shielding performance (Optical transmittance [%] at 360 nm wavelength) | | |
|---|---|---|---|---|---|---|---|---|---|---|---|
| | | Paint | Coating amount [g/m$^2$] | | | Initial | After wet heat test | After UV irradiation | Initial | After wet heat test | After UV irradiation |
| Example 1 | Film 1 | Paint 1 | 4.0 | A | A | AA | AA | AA | 1 or less | 1 or less | 1 or less |
| Example 2 | Film 2 | Paint 2 | 4.0 | A | A | AA | AA | AA | 1 or less | 1 or less | 1 or less |
| Example 3 | Film 3 | Paint 3 | 4.0 | A | A | AA | AA | AA | 1 or less | 1 or less | 1 or less |
| Example 4 | Film 4 | Paint 4 | 4.0 | A | A | AA | AA | AA | 1 or less | 1 or less | 1 or less |
| Example 5 | Film 5 | Paint 5 | 4.0 | A | A | AA | AA | A | 1 or less | 1 or less | 1 or less |
| Example 6 | Film 6 | Paint 6 | 4.0 | A | A | AA | A | AA | 1 or less | 1 or less | 1 or less |
| Example 7 | Film 7 | Paint 7 | 4.0 | A | A | AA | AA | A | 1 or less | 1 or less | 1.5 |
| Example 8 | Film 8 | Paint 8 | 4.0 | A | B | A | A | A | 1 or less | 1 or less | 1 or less |
| Example 9 | Film 9 | Paint 9 | 4.0 | B | A | AA | AA | AA | 1 or less | 1 or less | 1 or less |
| Comparative Example 1 | Film 10 | Paint 10 | 4.0 | A | A | AA | AA | AA | 1 or less | 1 or less | 1 or less |
| Comparative Example 2 | Film 11 | Paint 11 | 4.0 | A | A | AA | AA | AA | 1 or less | 1 or less | 1 or less |
| Comparative Example 3 | Film 12 | Paint 12 | 4.0 | A | A | AA | AA | AA | 1 or less | 1 or less | 1 or less |
| Comparative Example 4 | Film 13 | Paint 13 | 4.0 | A | A | AA | AA | A | 1 or less | 1 or less | 5 |
| Comparative Example 5 | Film 14 | Paint 14 | 4.0 | A | A | AA | AA | A | 1 or less | 3 | 2.5 |
| Comparative Example 6 | Film 15 | - | - | - | - | - | - | - | 59 | 61 | 46 |

[Table 4]

| | Film for backside sealing sheet of solar cell | Rein layer | | Surface resistance value [Ω/square] | | Partial discharge voltage [V] | | | | UV resistance Δb |
|---|---|---|---|---|---|---|---|---|---|---|
| | | Paint | Coating amount [g/m²] | Initial | After UV irradiation | Initial | After solvent resistance test | After wet heat test | After UV irradiation | |
| Example 1 | Film 1 | Paint 1 | 4.0 | $1\times10^{13}$ OIJ | $1\times10^{10}$ | 867 | 860 | 867 | 850 | 1.0 |
| Example 2 | Film 2 | Paint 2 | 4.0 | $1\times10^{9}$ | $1\times10^{7}$ | 796 | 780 | 831 | 800 | 1.5 |
| Example 3 | Film 3 | Paint 3 | 4.0 | $1\times10^{15}$ | $1\times10^{13}$ | 750 | 745 | 750 | 760 | 1.0 |
| Example 4 | Film 4 | Paint 4 | 4.0 | $1\times10^{13}$ | $1\times10^{15}$ | 873 | 862 | 872 | 710 | 1.8 |
| Example 5 | Film 5 | Paint 5 | 4.0 | $1\times10^{12}$ | $1\times10^{7}$ | 850 | 840 | 845 | 860 | 3.0 |
| Example 6 | Film 6 | Paint 6 | 4.0 | $1\times10^{15}$ | $1\times10^{14}$ | 740 | 735 | 750 | 745 | 0.9 |
| Example 7 | Film 7 | Paint 7 | 4.0 | $1x10^{11}$ | $1\times10^{7}$ | 850 | 845 | 850 | 870 | 4.0 |
| Example 8 | Film 8 | Paint 8 | 4.0 | $1\times10^{15}$ | $1\times10^{15}$ | 735 | 730 | 735 | 745 | 0.9 |
| Example 9 | Film 9 | Paint 9 | 4.0 | $1\times10^{13}$ | $1x10^{10}$ | 865 | 670 | 860 | 855 | 1.0 |
| Comparative Example 1 | Film 10 | Paint 10 | 4.0 | more than $1\times10^{15}$ | $1\times10^{15}$ | 710 | 705 | 710 | 720 | 1.0 |
| Comparative Examples 2 | Film 11 | Paint 11 | 4.0 | $1\times10^{5}$ or less | — | 781 | 775 | 788 | 760 | 2.2 |
| Comparative Example 3 | Film 12 | Paint 12 | 4.0 | more than $1\times10^{15}$ | — | 680 | 690 | 670 | 665 | 1.0 |
| Comparative Example 4 | Film 13 | Paint 13 | 4.0 | $1\times10^{9}$ | $1\times10^{5}$ or less | 876 | 870 | 875 | 880 | 12.2 |
| Comparative Example 5 | Film 14 | Paint 14 | 4.0 | $1\times10^{13}$ | $1\times10^{10}$ | 865 | 862 | 835 | 840 | 5.3 |
| Comparative Example 6 | Film 15 | — | — | more than $1\times10^{15}$ | — | 650 | — | 660 | 650 | 29.9 |

(Examples 1 to 9)

Films 1 to 3 for a backside sealing sheet of a solar cell of Examples 1 to 3 contained 5 to 20 mass% of conductive materials in their respective resin layers and were excellent in properties of partial discharge voltage. There was a tendency that the closer the content comes to 20 mass% the lower the surface resistance becomes, the closer the content comes to 5 mass%, the lower the partial discharge voltage becomes. Film 4 for a backside sealing sheet of a solar cell of Example 4 used the cationic antistatic agent as a conductive material, and thus showed a poor ultraviolet resistance, a decreased partial discharge voltage after the ultraviolet irradiation, and an increased $\Delta b$ value. Films 5 to 8 for a backside sealing sheet of a solar cell of Examples 5 to 8 had a content of the coloring pigment in the resin layer in the range of 35 to 75 mass%. When the content became less than 40 mass%, since ultraviolet-shielding performance was not enough, an increase in the $\Delta b$ value after ultraviolet irradiation was seen (Example 7). On the other hand, when the content exceeded 70 mass%, the amount of the filler became excessive. Thus, chalking was observed on the surface of the resin layer, and since the resin components were small in amount, the coating film adhesion was also decreased (Example 8). In Film 9 for a backside sealing sheet of a solar cell of Example 9, a biuret type hexamethylene diisocyanate resin, hardening agent, was used instead of the nurate type. Since hardening of the coating film was insufficient, solvent resistance was insufficient and peeling of the coating film was observed.

(Comparison between Examples 1 to 9 and Comparative Examples 1 to 3)

Film 10 for a backside sealing sheet of a solar cell of Comparative Example 1 contained 4 mass% of the conductive material in the resin layer. However, the mixing amount was insufficient to change the electric conductive property and surface resistance value of the resin layer, and failed to improve the partial discharge voltage. On the other hand, film 11 for a backside sealing sheet of a solar cell contained 25 mass% of the conductive material in the resin layer, but made the electric conductive property of the resin layer too high and the surface resistance value became $10^5$ $\Omega$/square or less. Comparative Example 3 did not include a conductive material in the resin layer. Therefore, the electric conductive property of the resin layer was insufficient like Comparative Example 1, and failed to improve the partial discharge voltage.

(Comparison between Examples 1 to 9 and Comparative Example 4)

Film 13 for a backside sealing sheet of a solar cell of Comparative Example 4 did not include any coloring pigment in the resin layer. Therefore, the resin layer could not be protected from ultraviolet rays, so the ultraviolet irradiation caused resin layer deterioration and disappearance of the resin layer, and surface resistance value fell to below 1.0 x $10^5$ $\Omega$/square. Since ultraviolet-shielding performance was insufficient, the $\Delta b$ value of the base film was increased by ultraviolet irradiation to 12.2, and yellowing occurred.

(Comparison between Examples 1 to 9 and Comparative Example 5)

In the film 14 for a backside sealing sheet of a solar cell of Comparative Example 5, the acrylic resin used to form the resin layer was prepared without cross-linking the ultraviolet absorbent and the light stabilizer (HALS) but by carrying out post-addition thereof. Therefore, in an environment of high temperature and high humidity, the ultraviolet absorbent and the light stabilizer bled out of the coat film to the surface of the resin layer, losing the ultraviolet-shielding performance. As a result, the $\Delta b$ value of the base film increased and yellowing occurred.

(Comparison between Examples 1 to 9 and Comparative Example 6)

Film 15 for a backside sealing sheet of a solar cell of Comparative Example 6, which is Lumirror (TM) (registered trademark) X10S film itself without any resin layer formed, was free of ultraviolet-shielding performance. In addition, a resin layer containing a conductive material responsible for an improvement in partial discharge voltage was not formed. Therefore, the partial discharge voltage was as low as 650 V, and resin deterioration and yellowing occurred when exposed to irradiation of ultraviolet light rays. Therefore, if it is used as the outermost layer of a solar-cell backside sealing sheet, in an extreme case, the film may suffer from cracks, pinholes or the like. Therefore, not only the functions, such as electric insulation and moisture barrier, required for a shielding sheet may be lost, but also there may occur adverse effect on the performance of the solar cell module.

(Example 10)

As a light reflective film, a white polyethylene terephthalate film Lumiror E20F (registered trademark) (50 $\mu$m)

manufactured by Toray Industries, Inc. was prepared. As a moisture barrier film, the opposite surface to the an aluminum vapor deposition layer of an alumina-deposited polyethylene terephthalate film Barrier-Locks (registered trademark) 1031HGTS (12 $\mu$m) manufactured by Toray Advanced Film Co., Ltd. was coated with a paint for adhesion layer formation and a paint for heat-bonding resin layer formation applied in this order with a double-head tandem type direct gravure coater under the following conditions to produce a film.

- Adhesion layer coating conditions: intended dried film thickness 0.2 $\mu$m, drying oven temperature setting 120°C
- Heat-bonding resin layer coating conditions: intended dried film thickness 1.0 $\mu$m, drying oven temperature setting 100°C
- Coating speed: 100 m/min.
- Aging: aging at 40°C for 2 days after coating and winding up.

On the base film surface opposite to the resin layer of the film 1 for a backside sealing sheet of a solar cell, a dry lamination adhesive was applied with a wire bar and then dried at 80°C for 45 seconds to form a 3.5-$\mu$m adhesive layer. Next, a light reflective layer was bonded to the adhesive layer using a hand roller. Furthermore, on the surface of the light reflective film opposite to the resin layer of the laminate film, a dry lamination adhesive was applied with a wire bar and then dried at 80°C for 45 seconds to form a 3.5-$\mu$m adhesive layer. Subsequently, an alumina vapor deposited layer surface of a moisture barrier film was bonded to the adhesive layer using a hand roller. A solar-cell backside sealing sheet 1 was obtained by aging a sheet composed of three films prepared in this way for three days in an oven heated at 40°C.

(Example 11)

A solar-cell backside sealing sheet 2 was obtained in a manner similar to the method described in Example 10, except that a white polyethylene film (100 $\mu$m) manufactured by Toray Advanced Film Co., Ltd. with an excellent adhesion to the EVA sheet was used instead of E20F and the moisture barrier film.

(Comparative Example 7)

A solar-cell backside sealing sheet 3 was obtained in a manner similar to the method described in Example 10, except that the film 11 for a backside sealing sheet of a solar cell of Comparative Example 2 was used instead of the film 1 for a backside sealing sheet of a solar cell.

(Comparative Example 8)

A solar-cell backside sealing sheet 4 was obtained in a manner similar to the method described in Example 10, except that the film 12 for a backside sealing sheet of a solar cell of Comparative Example 3 was used instead of the film 1 for a backside sealing sheet of a solar cell.

(Comparative Example 9)

A solar-cell backside sealing sheet 5 was obtained in a manner similar to the method described in Example 10, except that the film 15 for a backside sealing sheet of a solar cell of Comparative Example 6 was used instead of the film 1 for a backside sealing sheet of a solar cell.

[Table 51

| | Solar-cell sealing sheet | backside | Sheet structure | resin layer | |
|---|---|---|---|---|---|
| | | | | Paint | Coating amount [g/m$^2$] |
| Example 10 | Solar-cell sealing sheet 1 | backside | Heat-bonding resin layer/adhesion layer/Barrier-Locks 1031HGTS /adhesive layer/ Lumiror E20F/ adhesive layer/ Lumiror X10S/resin layer | Paint 1 | 4.0 |
| Example 11 | Solar-cell sealing sheet 2 | backside | Polyethylene film/ adhesive layer/ Lumiror X10S/resin layer | Paint 1 | 4.0 |
| Comparative Example 7 | Solar-cell sealing sheet 3 | backside | Heat-bonding resin layer/adhesion layer/Barrier-Locks 1031HGTS /adhesive layer/ Lumiror E20F/ adhesive layer/ Lumiror X10S/resin layer | Paint 11 | 4.0 |
| Comparative Example 8 | Solar-cell sealing sheet 4 | backside | Heat-bonding resin layer/adhesion layer/Barrier-Locks 1031HGTS /adhesive layer/ Lumiror E20F/ adhesive layer/ Lumiror X10S/resin layer | Paint 12 | 4.0 |
| Comparative Example 9 | Solar-cell sealing sheet 5 | backside | Heat-bonding resin layer/adhesion layer/Barrier-Locks 1031 HGTS /adhesive layer/ Lumiror E20F/ adhesive layer/ Lumiror X10S | - | - |

[Table 6]

| | Solar-cell backside sealing sheet | EVA sheet adhesion | Light reflectance (600nm) | Moisture transmission rate (°C, 90%RH) | Surface resistance value | Wet resistance | Partial discharge voltage [V] | Outermost-side UV resistance Δb |
|---|---|---|---|---|---|---|---|---|
| | | [N/50mm] | [%] | [g/(m$^2$·day)] | [Ω/square] | [MΩ] | | |
| Example 10 | Solar-cell backside sealing sheet 1 | 390 | 52 | 0.4 | $1×10^{13}$ | more than 400 | 1100 | 1.0 |
| Example 11 | Solar-cell backside sealing sheet 2 | 490 | 50 | 1.4 | $1×10^{13}$ | more than 400 | 1297 | 1.0 |
| Comparative Example 7 | Solar-cell backside sealing sheet 3 | 390 | 52 | 0.4 | $1×10^5$ or less | less than 400 | 1150 | 2.2 |
| Comparative Example 8 | Solar-cell backside sealing sheet 4 | 390 | 52 | 0.4 | more than $1×10^{15}$ | more than 400 | 850 | 1.0 |
| Comparative Example 9 | Solar-cell backside sealing sheet 5 | 390 | 51 | 0.4 | more than $1×10^{15}$ | more than 400 | 830 | 29.9 |

EP 2 509 112 A1

(Examples 10 and 11)

Solar-cell backside sealing sheets 1 and 2 of Examples 10 and 11, respectively, all have a high partial discharge voltage of 1,000 V or more, and can serve as good backside sealing sheets for solar cell modules at high system voltages. In addition, they did not suffer from a decrease in adhesion between the base film and the resin layer caused by ultraviolet irradiation on the resin layer located on the outermost side of the solar cell module structure. The resin layer and the base film hardly suffered from yellowing.

(Comparison between Examples 10 and 11 and Comparative Example 7)

Since in the solar-cell backside sealing sheet 3 of Comparative Example 7, a conductive material accounted for 25 mass% of the outermost resin layer, the electric conductivity of the resin layer became so high that the surface resistance value became $10^5$ Ω/square or less and the wet resistance became less than 400 MΩ. Therefore, high electric insulation, which is a property required in the solar-cell backside sealing sheet, could not be achieved.

(Comparison between Examples 10 and 11 and Comparative Example 8)

Since the solar-cell backside sealing sheet 4 of Comparative Example 8 did not contain any conductive material, it showed a partial discharge voltage as low as 850 V. This solar-cell backside sealing sheet 4 will not work effectively in a solar cell module application that requires a high system voltage.

(Comparison between Examples 10 and 11 and Comparative Example 9)

As for the solar-cell backside sealing sheet 5 of Comparative Example 9, the resin layer is not formed on the outermost side. In other words, both the partial discharge voltage and the ultraviolet resistance were low because it was free of a resin layer having ultraviolet-shielding performance or containing a conductive material. This solar-cell backside sealing sheet 5 cannot be used in a solar cell module application that requires a high system voltage or in a solar cell module application where it may be installed in a location with a possibility of exposure to ultraviolet rays reflected from the ground surface, such as in the case of a field installation type module.

According to the present invention, as is evident from each of the above examples and comparative examples, a film for a backside sealing sheet of a solar cell and a solar-cell backside sealing sheet having an excellent partial discharge voltage, which is one of major indexes of light resistance and electric insulation, are obtained.

In addition, the solar cell module using the solar-cell backside sealing sheet of the present invention is a solar cell module excellent in endurance.

[Industrial Applicability]

The film for a backside sealing sheet of a solar cell of the present invention is excellent in the partial discharge voltage which is an index of light fastness and electric insulation, and can be suitable for a solar-cell backside sealing sheet. Furthermore, this solar-cell backside sealing sheet can be suitably used in a solar cell module.

**Claims**

1.    A film for a backside sealing sheet of a solar cell comprising a base film with at least one of its surfaces being laminated with a resin layer containing a resin produced through copolymerization of an acrylic polyol resin with an ultraviolet absorbent and/or a light stabilizer, along with a conductive material and a coloring pigment, wherein the conductive material accounts for 5 to 20 mass% of the total mass of the resin layer and the resin layer has a surface resistivity of 1.0 x $10^9$ to 1.0 to $10^{15}$ Ω/square.

2.    A film for a backside sealing sheet of a solar cell as claimed in Claim 1, wherein the conductive material is a cationic antistatic agent and/or an inorganic solid conductive material.

3.    A film for a backside sealing sheet of a solar cell as claimed in Claim 2, wherein the inorganic solid conductive material has a fibrous structure.

4.    A film for a backside sealing sheet of a solar cell as claimed in Claim 3, wherein the inorganic solid conductive material is titanium oxide coated with tin oxide and in the form of needle-like crystals with a number-average fiber length in the range of 5 to 15 μm.

5. A film for a backside sealing sheet of a solar cell as claimed in any one of Claims 1 to 4, wherein the coloring pigment accounts for 40 to 70 mass% of the entire resin layer.

6. A film for a backside sealing sheet of a solar cell as claimed in any one of Claims 1 to 5, wherein the resin layer has a surface resistance of $1.0 \times 10^7$ to $1.0 \times 10^{15}$ Ω/square after being exposed to ultraviolet irradiation under the conditions of 60°C x 50% RH atmosphere and an accumulated ultraviolet irradiation dose of 384 kWh/m$^2$.

7. A film for a backside sealing sheet of a solar cell as claimed in any one of Claims 1 to 6, wherein the resin layer comprises at least one polyisocyanate resin selected from the group of aliphatic polyisocyanate resin, alicyclic polyisocyanate resin, aromatic polyisocyanate, and araliphatic polyisocyanate resin.

8. A solar-cell backside sealing sheet comprising a film for a backside sealing sheet of a solar cell as claimed in any one of Claims 1 to 7.

9. A solar cell module comprising a solar-cell backside sealing sheet as claimed in Claim 8 and a cell filler layer, wherein the solar-cell backside sealing sheet and the cell filler layer are bonded to each other.

## INTERNATIONAL SEARCH REPORT

| International application No. |
|---|
| PCT/JP2010/070960 |

### A. CLASSIFICATION OF SUBJECT MATTER
*H01L31/042*(2006.01)i

According to International Patent Classification (IPC) or to both national classification and IPC

### B. FIELDS SEARCHED

Minimum documentation searched (classification system followed by classification symbols)
H01L31/04-3/078

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2006-319250 A  (Keiwa Inc.),<br>24 November 2006 (24.11.2006),<br>paragraphs [0025] to [0046], [0058] to [0059],<br>[0066], [0090]<br>(Family: none) | 1-9 |
| Y | JP 1-261409 A  (Nippon Shokubai Kagaku Kogyo<br>Co., Ltd.),<br>18 October 1989 (18.10.1989),<br>claim 1<br>& US 5239028 A          & EP 337744 A2<br>& DE 68921500 C          & CA 1338946 A<br>& KR 10-1994-0004720 B | 1-9 |

☒ Further documents are listed in the continuation of Box C.          ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>22 February, 2011 (22.02.11) | Date of mailing of the international search report<br>08 March, 2011 (08.03.11) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2010/070960

C (Continuation).    DOCUMENTS CONSIDERED TO BE RELEVANT

| Category* | Citation of document, with indication, where appropriate, of the relevant passages | Relevant to claim No. |
|---|---|---|
| Y | JP 2005-314561 A  (Chuden-Kogyo Co., Ltd.),<br>10 November 2005 (10.11.2005),<br>paragraphs [0024] to [0025]<br>(Family: none) | 1-9 |
| P,X | WO 2010/061738 A1  (Toray Industries, Inc.),<br>03 June 2010 (03.06.2010),<br>entire text<br>(Family: none) | 1-9 |
| A | JP 2009-147063 A  (Toray Advanced Film Co., Ltd.),<br>02 July 2009 (02.07.2009),<br>abstract; claims; drawings<br>(Family: none) | 1-9 |
| A | JP 2009-200385 A  (Toppan Printing Co., Ltd.),<br>03 September 2009 (03.09.2009),<br>abstract; claims; drawings<br>(Family: none) | 1-9 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002100788 A

- JP 2006253264 A